# EUROPEAN PATENT APPLICATION

(11) **EP 1 411 554 A1**
(43) Date of publication of application: **21.04.2004**
(21) Application number: 02741291.5
(22) Date of filing: 25.06.2002
(51) Int. Cl.: H01L 29/78

(54) **FIELD-EFFECT TRANSISTOR CONSTITUTING CHANNEL BY CARBON NANO TUBES**

(30) Priority: 05.07.2001 JP 2001204182
(71) Applicant: NEC Corporation, Minato-ku, Tokyo 108-8001 (JP)
(72) Inventor: NIHEY, Fumiyuki, Minato-ku, Tokyo 108-8001 (JP)
(74) Representative: Patentanwälte Wenzel & Kalkoff
(86) International application number: PCT/JP2002/006355
(87) International publication number: WO 2003/005451

(57) **Abstract**

A field-effect transistor has a channel disposed on a substrate, a source electrode connected to a starting end of the channel, a drain electrode connected to a terminal end of the channel, an insulator disposed on an upper or side surface of the channel, and a gate electrode disposed on the upper or side surface of the channel with the insulator interposed therebetween. The channel is made of a plurality of carbon nanotubes.

## Description

### Technical field

The present invention relates to a field-effect transistor for controlling or amplifying a digital electric signal or an analog electric signal which has a very high frequency.

### Background art

With the tendency in recent years toward high-speed information processing and communications, there have been growing demands for electronic devices for controlling or amplifying a digital electric signal or an analog electric signal which has a very high frequency of 100 GHz or more.

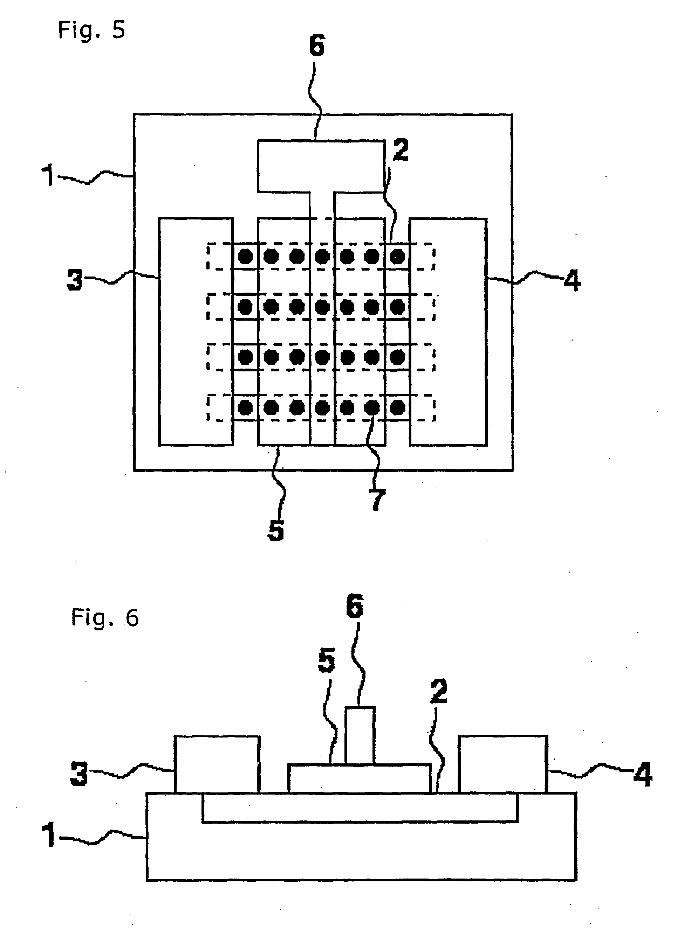

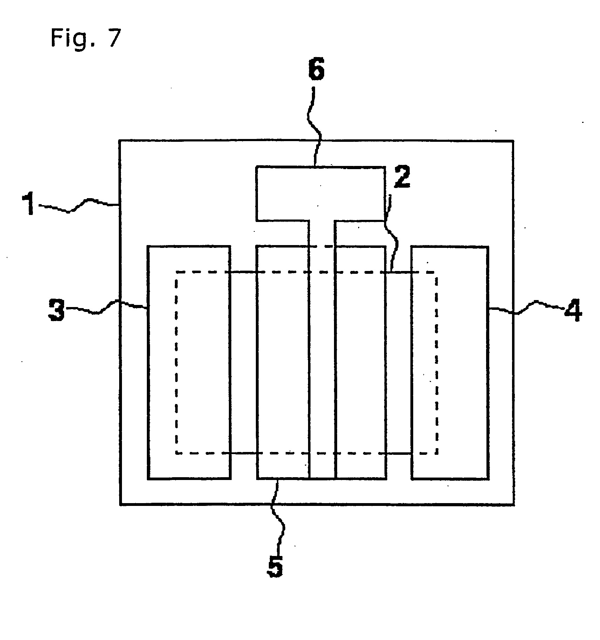

One representative electronic device for use in the above applications is a field-effect transistor made of a III - V group compound such as GaAs or the like. A typical field-effect transistor is shown in cross section in Fig. 6 of the accompanying drawings, and shown in plan in Fig. 7 of the accompanying drawings. As shown in Figs. 6 and 7, the field-effect transistor has substrate 1, channel 2, source electrode 3, drain electrode 4, insulator 5, and gate electrode 6. The channel is generally made of a semiconductor and contains charged particles that contribute to electric conduction. The charged particles are electrons or holes.

The field-effect transistor is a device for converting a voltage signal that is input to the gate electrode into a current signal that is output from the source electrode or the drain electrode. When a voltage is applied between the source electrode and the drain electrode, charged particles that are present in the channel move along the direction of the electric field between the source electrode and the drain electrode, and are output as the current signal from the source electrode or the drain electrode. The current signal is proportional to the density and speed of the charged particles. When a voltage is applied to the gate electrode that is held against an upper or side surface of the channel with the insulator interposed therebetween, the density of the charged particles in the channel varies. Therefore, the current signal can be changed by changing the voltage applied to the gate electrode.

The operating speed of the field-effect transistor is determined by the time in which the charged particles travel through the channel. More specifically, the operating speed of the field-effect transistor is determined by the time in which the charged particles travel over the length (gate length) of a portion of the channel which is held in contact with the gate electrode through the insulator. When the voltage applied between the source electrode and the drain electrode increases, the traveling speed of the charged particles in the channel increases. However, the traveling speed of the charged particles does not increase beyond a certain value because the scattering probability is higher as the traveling speed is higher. The certain value is referred to as saturation speed. The cutoff frequency f_{T} which is an index of the operating speed of the field-effect transistor is expressed by f_{T} = vₛ/2πI_{g} where vₛ represents the saturation speed of the charged particles and I_{g} the gate length.

In order to increase the operating speed, i.e., the cutoff frequency, either the saturation speed may be increased or the gate length may be reduced. The gate length is determined by a micromachining process performed on the gate electrode, and can be reduced to about 0.1 µm at present. In order to increase the saturation speed, the channel may be made of a semiconductor having a high saturation speed. At present, gallium arsenide is widely used as such a semiconductor and has a saturation speed of 1 × 10⁷ cm/s. If the gate length is 0.1 µm, then the cutoff frequency is 160 GHz.

The tendency in recent years toward high-speed information processing and communications has resulted in a need for electronic devices for controlling or amplifying a digital electric signal or an analog electric signal which has a frequency higher than the frequencies that can be processed by field-effect transistors made of gallium arsenide. Therefore, there has been a demand for field-effect transistors made of a material having a higher saturation speed.

### Disclosure of the invention

According to the present invention, there is provided a field-effect transistor having a channel disposed on a substrate, a source electrode connected to a starting end of the channel, a drain electrode connected to a terminal end of the channel, an insulator disposed on an upper surface of the channel, and a gate electrode disposed on the upper surface of the channel with the insulator interposed therebetween, characterized in that the channel is made of carbon nanotubes.

The field-effect transistor is more effective if the carbon nanotubes are semiconductive. The carbon nanotubes may be single-layer carbon nanotubes or multilayer carbon nanotubes.

There is also provided a field-effect transistor in which a charged particle donor is added to the carbon nanotubes. There is also provided a field-effect transistor in which the charged particle donor comprises an alkaline metal. There is further provided a field-effect transistor in which the charged particle donor comprises halogen molecules.

There is also provided a field-effect transistor having a channel constructed of carbon nanotubes, characterized in that a charged particle donor is contained in the carbon nanotubes. There is further provided a field-effect transistor in which a channel is constructed of carbon nanotubes containing fullerenes.

By suppressing impurity scattering or lattice scattering, the saturation speed of carbon nanotubes reaches 8 × 10⁷ cm/s, which is eight times the saturation speed of gallium arsenide. We have found that a field-effect transistor having a cutoff frequency of 1 THz or higher can be obtained by using such material as the channel.

Since the diameter of carbon nanotubes is very small, there is a limitation on a current that can flow through one single-layer carbon nano-tube, and the current is about 1 µA at maximum. Practically, a current signal of a field-effect transistor is required to be about 1 mA. If the channel is constructed of an array of carbon nanotubes, then a practically feasible field-effect transistor can be provided. The array ranges from 10 to 100 thousand carbon nanotubes.

An ordinary field-effect transistor performs switching operation across a certain gate voltage (threshold voltage). The voltage value of the gate voltage is determined by the characteristics of the channel itself and a charged particle donor. A charged particle donor may be added to the channel for the purpose of adjusting the threshold voltage.

Usually, charged particle donors include an electron donor and a hole donor. It is known that an alkaline metal such as sodium, potassium, rubidium, cesium, or the like is effective as the electron donor. It is also known that halogen atoms or halogen molecules of chlorine, bromine, iodine, or the like are effective as the hole donor. Molecules also work as a charged particle donor. For example, ammonia or benzalkonium chloride works as an electron donor, and oxygen molecules as a hole donor. If the electron donor is added, the field-effect transistor operates as an n-type field-effect transistor, and the threshold voltage thereof may be adjusted in a negative direction by increasing the added amount of electron donor. If the hole donor is added, the field-effect transistor operates as a p-type field-effect transistor, and the threshold voltage thereof may be adjusted in a positive direction by increasing the added amount of hole donor.

The charged particle donor may be present outside of the carbon nanotubes or may be contained in the carbon nanotubes. If the charged particle donor is contained in the carbon nanotubes, it is less susceptible to external effects, allowing the field-effect transistor to have stable electrical characteristics.

### Brief description of the drawings

Fig. 1 is a schematic cross-sectional view of a field-effect transistor according to a first embodiment of the present invention;
Fig. 2 is a schematic plan view of the field-effect transistor according to the first embodiment of the present invention;
Fig. 3 is a schematic cross-sectional view of the field-effect transistor according to the first embodiment of the present invention with an insulating film disposed on a conductive substrate;
Fig. 4 is a schematic plan view of a field-effect transistor according to a second embodiment of the present invention;
Fig. 5 is a schematic plan view of a field-effect transistor according to a third embodiment of the present invention;
Fig. 6 is a schematic cross-sectional view of a conventional field-effect transistor; and
Fig. 7 is a schematic plan view the conventional field-effect transistor.

### Best mode for carrying out the invention

Embodiments of the present invention will be described below with reference to the drawings.

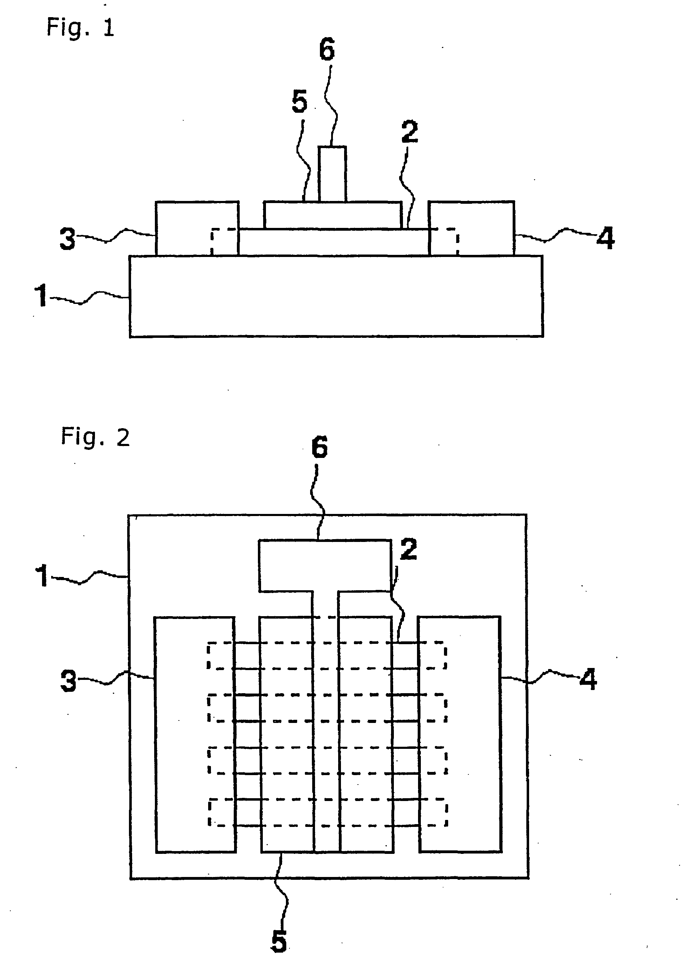

Fig. 1 is a schematic view showing a sectional structure of a first embodiment of a field-effect transistor according to the present invention. Fig. 2 is a schematic plan view of the first embodiment. As shown in Figs. 1 and 2, the field-effect transistor has substrate 1, channel 2, source electrode 3, drain electrode 4, insulator 5, and gate electrode 6.

The substrate may comprise an insulating substrate or a semiconductor substrate. The insulating substrate may be made of silicon oxide, silicon nitride, aluminum oxide, titanium oxide, calcium fluoride, an insulating resin such as acrylic resin or epoxy resin, polyimide, tetrafluoroethylene, or the like. The semiconductor substrate may be made of silicon, germanium, gallium arsenide, indium phosphorus, silicon carbide, nium, gallium arsenide, indium phosphorus, silicon carbide, or the like. The substrate should preferably have a flat surface.

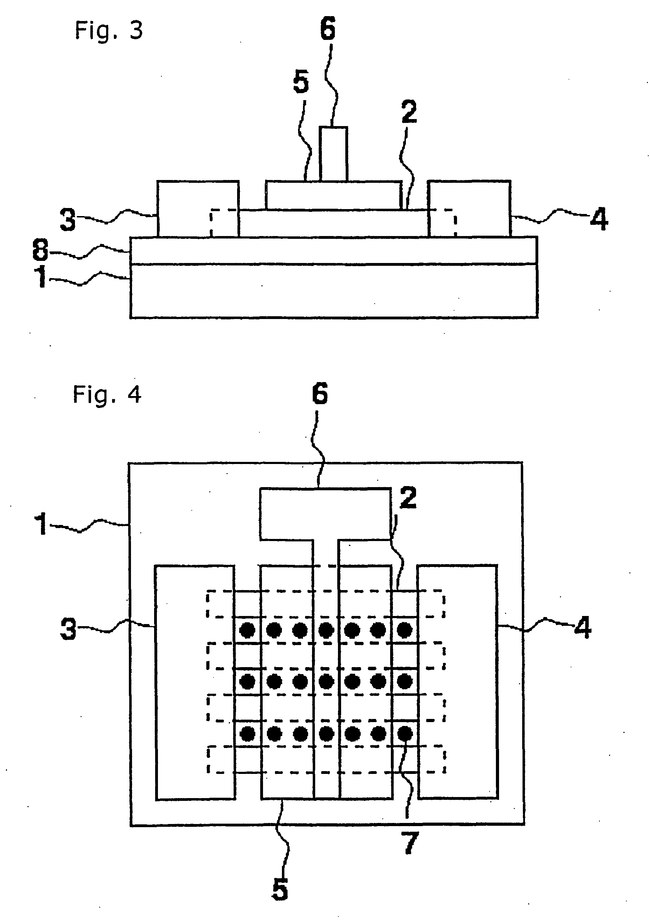

As shown in Fig. 3, the field-effect transistor may be of such structure that an insulating film is disposed on a conductive substrate. With such structure, the conductive substrate may also operate as a second gate electrode.

A plurality of carbon nanotubes is arrayed between the source electrode and the drain electrode, providing the channel therebetween. The present invention is not limited to any processes of synthesizing carbon nanotubes. Carbon nanotubes may be synthesized by a laser ablation process, an arc discharge process, or a chemical vapor deposition process. The carbon nanotubes may be single-layer carbon nanotubes or multilayer carbon nanotubes. Adjacent ones of the carbon nanotubes arrayed in the channel may be spaced from each other by a distance ranging from 0.3 nm to 10 µm. The carbon nanotubes may be arrayed not only in a horizontal direction, but also simultaneously in a vertical direction.

The carbon nanotubes have opposite ends electrically connected to the source electrode and the drain electrode.

One process of arraying carbon nanotubes on a substrate employs a self-organizing molecular film. For example, a portion of a substrate is covered with an aminopropylethoxysilane molecular film, and the other portion with a hexamethyldisilazane molecular film. The former molecular film has the property of being charged positively. Since carbon nanotubes have the property of being charged negatively, they are selectively adsorbed to the former molecular film, and hardly adsorbed to the latter molecular film. Because a molecular film can be patterned to shape by an electron beam exposure process or an optical exposure process, nanotubes can be placed and arrayed in any desired positions.

According to a process of manipulating carbon nanotubes, optical tweezers are used. Specifically, when a light beam is converged, micron-size particles are put together. Carbon nanotubes may be piled in the channel according to this process. Alternatively, carbon nanotubes may be arrayed based on their property that they tend to be oriented in the direction of an electric field.

The source electrode and the drain electrode may be made of a metal. For example, they may be made of gold, silver, platinum, titanium, titanium carbide, tungsten, aluminum, molybdenum, chromium, or the like. The source electrode and the drain electrode may be attached to the distal ends of the carbon nanotubes or sides thereof. The source electrode and the drain electrode may be formed before the channel is formed or after the channel is formed. When the source electrode and the drain electrode are formed, they may be heated to a temperature ranging between 300°C and 1000°C for better electrical connection. Alternatively, the substrate may be coated with a resist in which carbon nanotubes are dispersed, and the resist may be exposed to a pattern and developed, after which the electrodes may be applied to the resist.

The gate electrodes may be formed directly on the carbon nanotubes, or may be formed on the carbon nanotubes with an insulating film interposed therebetween. The insulating film may be made of an inorganic material such as silicon oxide, silicon nitride, aluminum oxide, titanium oxide, calcium fluoride, or the like, or a polymeric material such as acrylic resin, epoxy resin, polyimide, tetrafluoroethylene, or the like, or a self-organizing molecular film such as of aminopropylethoxysilane. Since there are no dangling bonds on the sides of the carbon nanotubes, they are chemically inactive, allowing insulators to be selected with freedom.

The gate electrode may be made of a conductor such as, for example, gold, silver, platinum, titanium, titanium carbide, titanium nitride tungsten, tungsten silicide, tungsten nitride, aluminum, molybdenum, chromium, polycrystalline silicon, or a combination thereof.

Carbon nanotubes may be used as the gate electrode. In such a case, a very short gate length can be obtained. The carbon nanotubes that are used may be single-layer carbon nanotubes, multilayer carbon nanotubes, or carbon nanotubes containing a metal. Metallic carbon nanotubes are preferable.

Fig. 4 is a schematic plan view of a second embodiment of a field-effect transistor according to the present invention. The field-effect transistor has substrate 1, channel 2, source electrode 3, drain electrode 4, insulator 5, gate electrode 6, and charged particle donor 7. The charged particle donor gives electrons or holes to carbon nanotubes for thereby controlling the density of charged particles that are present in the carbon nanotubes.

The electron donor may be an alkaline metal such as sodium, potassium, rubidium, cesium, or the like. The hole donor may be halogen atoms or halogen molecules of chlorine, bromine, iodine, or the like. Alternatively, oxygen molecules or molecules of ammonia, benzalkonium chloride and the like may be used as the charged particle donor.

Fig. 5 is a schematic plan view of a third embodiment of a field-effect transistor according to the present invention. Charged particle donor 7 is present inside carbon nanotubes. Fullerenes may be used as the charged particle donor. For example, C₆₀, C₇₀, C₇₆, C₇₈, C₈₂, C₈₄, or C₉₂ may be used. Alternatively, fullerenes chemically modified by an osmium complex or fluorine may be used. Fullerenes may contain other atoms or molecules. For example, fullerenes containing La, Er, Gd, Ho, Nd, Y, Sc, Sc₂, or Sc₃N may be used. These fullerenes operate effectively as the charged particle donor.

Electrons or holes may be supplied to carbon nanotubes by a manufacturing process based on the application of radiation or metal evaporation.

### Industrial applicability

According to the present invention, since a channel can be constructed of carbon nanotubes providing a gate length equivalent to those of conventional field-effect transistors of III - V group compounds and having a very large saturation speed, there is realized a field-effect transistor for controlling or amplifying a digital electric signal or an analog electric signal which has a very high frequency.

## Claims

1. A field-effect transistor having a channel for charged particles to travel therein, a source region and a drain region which are connected respectively to portions of the channel, and a gate electrode electromagnetically coupled to the channel, **characterized in that** said channel is made of carbon nanotubes.

2. A field-effect transistor according to claim 1, **characterized in that** said carbon nanotubes have semiconductive electric characteristics.

3. A field-effect transistor according to claim 1 or 2, **characterized in that** said carbon nanotubes include single-layer carbon nanotubes or multilayer carbon nanotubes, said carbon nanotubes being either helical or non-helical.

4. A field-effect transistor according to any one of claims 1 through 3, **characterized in that** a charged particle donor is added to said carbon nanotubes.

5. A field-effect transistor according to claim 4, **characterized in that** said charged particle donor comprises an alkaline metal.

6. A field-effect transistor according to claim 4, **characterized in that** said charged particle donor comprises halogen atoms or halogen molecules.

7. A field-effect transistor according to claim 4, **characterized in that** said charged particle donor comprises ammonia or benzalkonium chloride.

8. A field-effect transistor according to any one of claims 1 through 7, **characterized in that** said carbon nanotubes contain a charged particle donor.

9. A field-effect transistor according to claim 8, **characterized in that** said charged particle donor contained in said carbon nanotubes comprises fullerene.

10. A field-effect transistor according to claim 9, **characterized in that** said fullerene is chemically modified.

11. A field-effect transistor according to claim 9 or 10, **characterized in that** said fullerene contains a metal or molecules.

12. A field-effect transistor according to any one of claims 1 through 11, **characterized in that** said gate electrode is connected to said channel through an insulating film.

13. A field-effect transistor according to any one of claims 1 through 12, **characterized in that** gate electrode comprises carbon nanotubes.
